# EUROPEAN PATENT SPECIFICATION

(11) **EP 2 890 227 B1**
(45) Date of publication and mention of the grant of the patent: **11.09.2019**
(21) Application number: 13831772.2
(22) Date of filing: 26.07.2013
(51) Int. Cl.: H05K 7/20, H02M 3/00, H02M 7/48

(54) **ELECTRIC POWER CONVERSION APPARATUS**
STROMWANDLERVORRICHTUNG
APPAREIL DE CONVERSION DE PUISSANCE ÉLECTRIQUE

(30) Priority: 24.08.2012 JP 2012184769
(43) Date of publication of application: 01.07.2015
(73) Proprietor: Hitachi Industrial Equipment Systems Co., Ltd., Chiyoda-ku Tokyo 101-0022 (JP)
(72) Inventor: HAMANO, Koji, Tokyo 101-0022 (JP); YAMAZAKI, Tadashi, Tokyo 101-0022 (JP); HIROTA, Masayuki, Narashino-shi Chiba 275-0001 (JP); NAKAMURA, Hiroshi, Tokyo 101-0022 (JP)
(74) Representative: Strehl Schübel-Hopf & Partner
(86) International application number: PCT/JP2013/070278
(87) International publication number: WO 2014/030494

(56) References cited:
- EP-A2- 0 356 991
- JP-A- 2003 198 169
- JP-A- 2013 093 364
- JP-U- S6 115 471
- JP-U- H01 180 104

## Description

### Technical Field

The present invention relates to a cooling structure of an electric power conversion apparatus.

### Background Art

In an electric power conversion apparatus, a semiconductor such as IGBT and DM (diode module) converts inputted electric power. Regarding cooling of heat generated by a loss generated when the electric power is converted, for example, PTL 1 (JP-A-2004-71594) discloses a cooling structure and an electric power conversion apparatus including the same, each of which includes: a board frame 2; partitions 8a and 8b partitioning the board frame 2; a heat pipe 9 passing through the partitions 8a and 8b and including a heat radiating section 7 above the partitions 8a and 8b; an electric component 6 provided below the partitions 8a and 8b; an inlet port 4 and an exhaust port 5 directly communicating with outside and provided in a door 3a above the partitions 8a and 8b; communicative ports 11 and 12 allowing a portion where the heat radiating section 7 is provided to communicate with a portion where the electric component 6 is provided, the communicative ports 11 and 12 being provided in the partitions 8a and 8b; and a guide plate 10 provided to the communicative port 11 for inhaling air, whereby a flow of air is introduced from the outside into a whole interior of the board frame 2 and the electric component 6 is cooled by natural convection of introduced air in addition to absorption and radiation of heat with use of the heat pipe 9.

PTL 2 (JP-A-2009-033910) discloses an electric power conversion apparatus including: a casing for covering cooling fins for cooling power semiconductors; a main circuit board having a driver circuit for driving the power semiconductors; a cover for covering the main circuit board; a first airflow hole provided in a part of the main circuit board, the part being on an upper side of an air-intake hole provided in the cover; and a second airflow hole provided on a lower side of the first airflow hole and the cooling fins, wherein air from the second airflow hole is flowed by a cooling fan to the cooling fins.

Further, JP 2003 198169 A discloses an electric power conversion apparatus from which the pre-characterising part of claim 1 starts out.

### Citation List

### Patent Literature

PTL 1: JP-A-2004-71594
PTL 2: JP-A-2009-033910

### Summary of Invention

### Technical Problem

As described in PTL 1, cooling of heat generated by a loss generated when electric power is converted in the electric power conversion apparatus is generally performed by natural air cooling with the use of a cooling fin, by forced air cooling with the use of a cooling fin and a cooling fan, or by cooling by providing a flow channel on a base of a cooling fin with the use of a water-cooling apparatus or the like, thereby preventing thermal destruction of a semiconductor caused by rise in temperature.

A size of a main circuit board needs to be reduced as a size of an electric power conversion apparatus is reduced. As a result, the main circuit board is mounted with high density. Many components such as an aluminum electrolytic capacitor and a resistor are mounted on the main circuit board, and therefore heat generated from the main circuit board cannot be ignored. Because the main circuit board is mounted with high density, gaps among the components are reduced, and therefore cooling air for cooling cannot be easily flowed. Consequently, in those conventional electric power conversion apparatus, there are problems that the components cannot be easily cooled by natural convection of cooling air and heat of the cooling fin that absorbed heat generated from the semiconductor is transmitted to the main circuit board.

As described in PTL 2, in some cases, many opening portions for cooling are provided in a main body casing for protecting the main circuit board. The opening portions play an important role in absorption and discharge of air for cooling the main circuit board, however, because of that, the opening portions attract, into the main body casing, dust floating in a place where the electric power conversion apparatus is provided. As a result, there is a problem that, because components mounted on the main circuit board are short-circuited due to dust and the like, the main body casing cannot achieve an original role, i.e., cannot protect the main circuit board.

Further, dust is deposited on the opening portions in a rough environment, and, in a case where the dust is tried to be removed, the dust enters inside of the main body casing through the opening portions of the main body casing, with the result that, when the electric power conversion apparatus is turned on without removing the dust, the components are short-circuited. Furthermore, in a case where the dust is deposited on the opening portions of an upper surface wall of the main body casing and is left untouched, there is a possibility that heat generated from the main circuit board cannot be emitted to outside, which results in thermal destruction of the components mounted on the circuit board.

In a case where the electric power conversion apparatus is provided, original cooling performance cannot be obtained unless the electric power conversion apparatus has a given space on right and left and upper and lower sides thereof in order to cool the semiconductor and cool the main circuit board. Thus, even if the size of the conventional electric power conversion apparatus is reduced, a user needs to secure a cooling space when the electric power conversion apparatus is installed. As a result, the user needs to secure a large installation environment.

An object of the invention is to provide an electric power conversion apparatus that solves the above problems, improves coolability at a low cost, improves safety of operation of the apparatus, and reduce an installation space.

### Solution to Problem

In order to solve the above problems, features recited in claim 1 are employed.

The problems can be achieved by, as an example, an electric power conversion apparatus including: a semiconductor; a main circuit board having a circuit for driving the semiconductor; a main body casing housing the main circuit board and the semiconductor; a cooling fin for radiating heat of the semiconductor; a cooling fan for cooling the cooling fin; and an upper surface cover for controlling a direction of air discharged from the cooling fan, the electric power conversion apparatus being structured so that: the main body casing has a box shape and has a plurality of opening portions on an upper surface wall and a lower surface wall thereof in order to cool the main circuit board; air from the cooling fan rectified by the upper surface cover is flowed near surfaces of the opening portions provided in the upper surface wall; and heat radiated from the main circuit board housed in the main body casing is absorbed by setting a negative pressure state in a place near the surfaces of the opening portions of the upper surface wall.

### Advantageous Effects of Invention

According to the invention, it is possible to provide an electric power conversion apparatus capable of improving coolability at a low cost, improving safety, and reducing an installation space.

### Brief Description of Drawings

Fig. 1 is a schematic view of a conventional electric power conversion apparatus.
Fig. 2 is a schematic view of a structure in which opening portions provided in an upper surface wall of a main body casing and an upper surface cover of an electric power conversion apparatus according to Example 1 of the invention have a space.
Fig. 3 is a schematic view of a structure of an electric power conversion apparatus according to Example 2 of the invention, in which an upper surface cover is inclined.
Fig. 4 is a schematic view of a structure of an electric power conversion apparatus according to Example 3 of the invention, in which an upper surface cover is inclined while being curved.
Fig. 5 is a schematic view of a structure of an electric power conversion apparatus according to Example 4 of the invention, in which an upper surface cover has a semicircular dome shape and becomes narrower from the middle.
Fig. 6 is a schematic view illustrating a flow of cooling air in the conventional electric power conversion apparatus seen from a right side surface thereof.
Fig. 7 is a schematic view illustrating a flow of cooling air in the electric power conversion apparatus according to Example 1 of the invention seen from a right side surface thereof.
Fig. 8 is a schematic view illustrating a flow of cooling air in the electric power conversion apparatus according to Example 2 of the invention seen from a right side surface thereof.
Fig. 9 is a schematic view illustrating a flow of cooling air in the electric power conversion apparatus according to Example 3 of the invention seen from a right side surface thereof.
Fig. 10 is a schematic view illustrating a flow of cooling air in the electric power conversion apparatus according to Example 4 of the invention seen from a right side surface thereof.
Fig. 11 is a schematic view of comparison between influences of dust in the electric power conversion apparatus according to Examples 1 to 4 of the invention seen from right side surfaces thereof.

### Description of Embodiments

Examples of an electric power conversion apparatus according to the invention will be described below with reference to drawings.

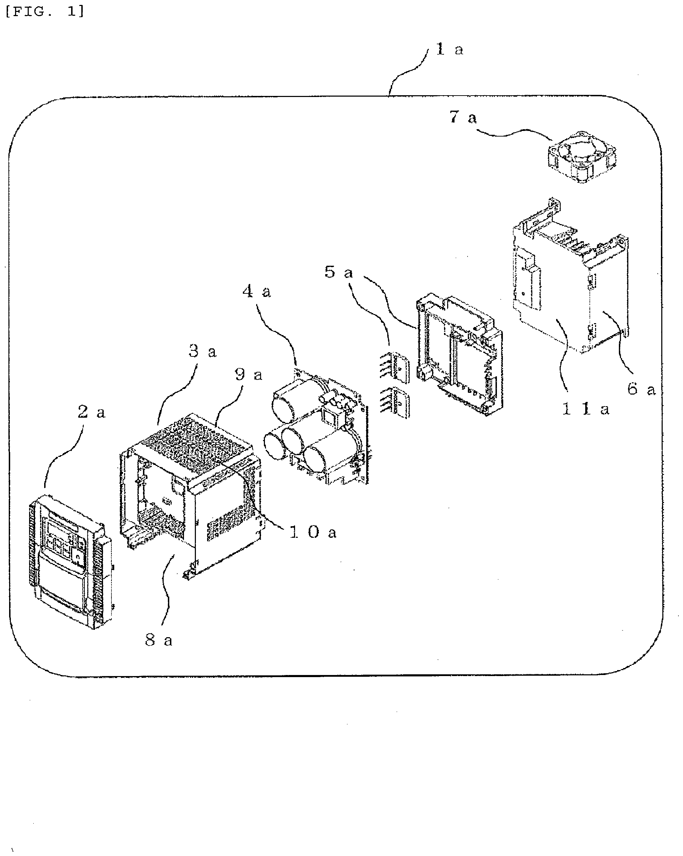

First, a conventional electric power conversion apparatus will be described. Fig. 1 is a schematic view of a conventional electric power conversion apparatus 1a, and Fig. 1 is an exploded view of components in a state in which the electric power conversion apparatus 1a is installed and is normally used.

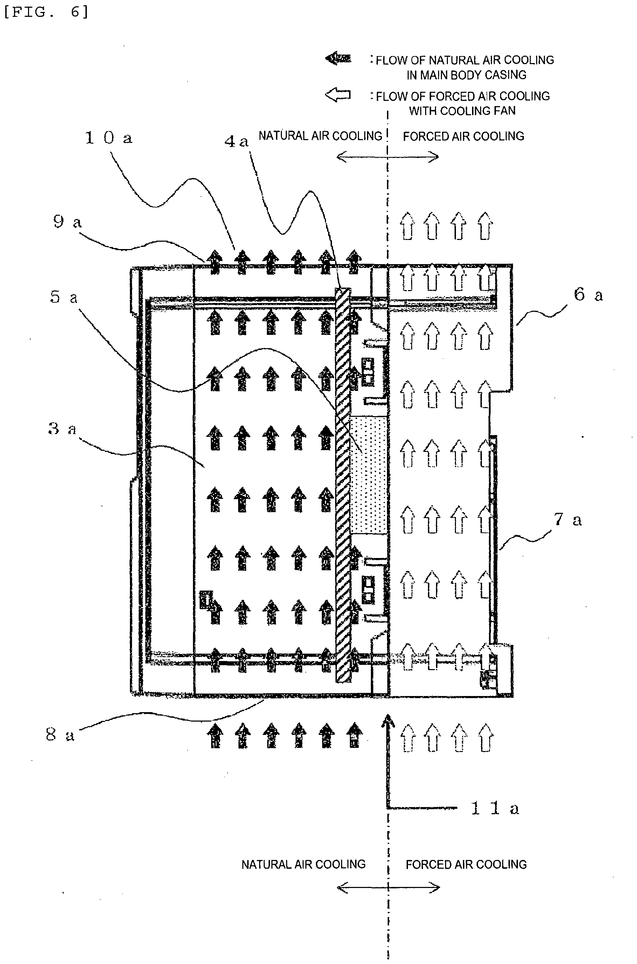

Fig. 6 is a cross-sectional view of the conventional electric power conversion apparatus seen from a side surface thereof and illustrates a flow of cooling air.

In Fig. 1, the electric power conversion apparatus 1a includes a semiconductor 5a for converting inputted direct-current power into alternating-current power and a main circuit board 4a for driving the semiconductor 5a, and the main circuit board 4a and the semiconductor 5a are covered up by a main body casing 3a.

A surface cover 2a is provided to a surface opposite to a surface to which the main circuit board 4a and the semiconductor 5a in the main body casing 3a are connected, and a plurality of opening portions 10a are provided in a lower surface 8a and an upper surface wall 9a orthogonal to a surface at which the main body casing 3a is provided so that air can be flowed in and flowed out.

In a state in which the electric power conversion apparatus 1a is normally used, the surface cover 2a is placed on a front near side, a cooling fin 6a is placed on a back side (wall side), and the lower surface 8a of the main body casing is placed on a lower side.

Herein, cooling of the semiconductor 5a will be described. The main circuit board 4a is fixed to the semiconductor 5a with solder, the semiconductor 5a is attached to a cooling fin base surface 11a of the cooling fin 6a adjacent to the semiconductor 5a, heat generated in the semiconductor 5a is transmitted to the cooling fin 6a, and forced air cooling is performed by a cooling fan 7a fixed to an upper surface of the cooling fin 6a. Specifically, as illustrated in Fig. 6, heat generated in the semiconductor 5a is transmitted to cooling air of the cooling fan 7a, and the cooling air is discharged toward the upper surface of the cooling fin 6a from a lower surface thereof, with the result that the cooling air discharged from the cooling fin 6a is flowed upward.

Cooling of the main circuit board 4a will be described. The main circuit board 4a is cooled by natural air cooling with the use of the opening portions 10a provided in the main body casing 3a. Specifically, as illustrated in Fig. 6, cooling air for the main circuit board 4a is flowed toward the upper surface wall 9a provided on an upper part of the main body casing 3a from the lower surface 8a of the main body casing 3a and is discharged through the plurality of opening portions 10a provided in the upper surface wall 9a, with the result that the cooling air discharged through the plurality of opening portions 10a is also flowed upward.

That is, both the cooling air that has absorbed heat generated from the semiconductor 5a and the cooling air for the main circuit board 4a are flowed upward from a lower side in the electric power conversion apparatus, however, those two kinds of cooling air are completely separated by the base surface 11a of the cooling fin 6a to which the semiconductor 5a is fixed. Thus, cooling of the cooling fin 6a and cooling of the main circuit board 4a are completely independent. After being discharged to outside of the electric power conversion apparatus, the two kinds of cooling air are separately flowed upward. Thus, cooling of the cooling fin 6a and cooling of the main circuit board 4a are completely independent.

### Example 1

In this example, the basic structure of the electric power conversion apparatus that has been described with reference to Fig. 1 is omitted, and a difference between this example and the conventional electric power conversion apparatus will be described.

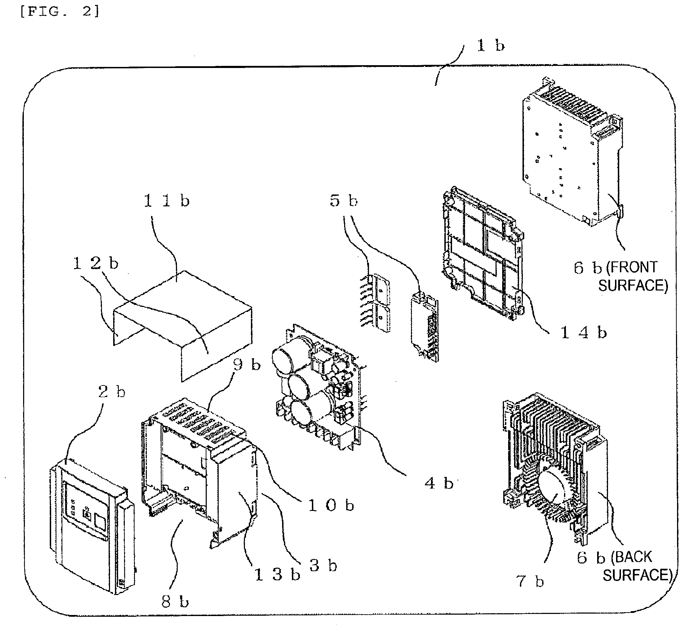

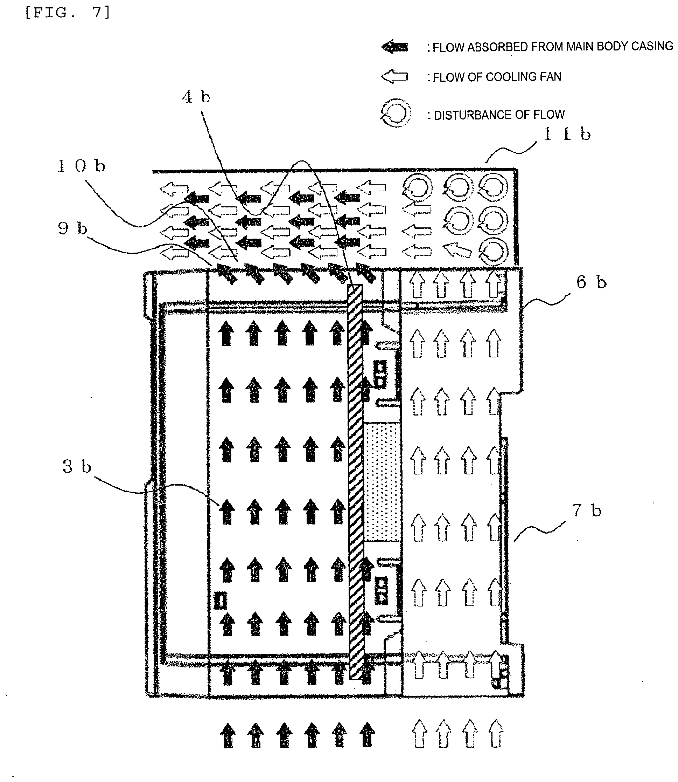

Fig. 2 is an example of a structural view of an electric power conversion apparatus 1b in this example. Fig. 7 is a cross-sectional view of the electric power conversion apparatus 1b in this example seen from a side thereof and illustrates a flow of cooling air. In Example 1, an upper surface cover 11b is provided above opening portions 10b and a cooling fin 6b.

In the electric power conversion apparatus 1b in this example, the upper surface cover 11b is provided to have a predetermined space above the opening portions 10b provided in an upper surface wall 9b of a main body casing 3b and the cooling fin 6b of the electric power conversion apparatus 1b.

Herein, a structure of the upper surface cover 11b, which is a feature in this example, will be described.

Walls 12b are provided on right and left side surfaces of the upper surface cover 11b, and those walls are in contact with right and left walls 13b of the main body casing 3b. Therefore, air cannot be flowed in or flowed out through the right and left side surfaces of the upper surface cover 11b.

A wall is also provided on a back side surface of the upper surface cover 11b. Therefore, air cannot be also flowed in or flowed out through the back side surface of the upper surface cover 11b.

A cover is also provided on an upper surface of the upper surface cover 11b. Therefore, air cannot be also flowed in or flowed out through the upper surface of the upper surface cover 11b.

Therefore, in the conventional electric power conversion apparatus la, cooling air from the cooling fan 7a passes through an upper surface of the cooling fan 7a and is discharged upward. However, in this example, as illustrated in the cross-sectional view of the electric power conversion apparatus 1b in Fig. 7, after cooling air emitted from a cooling fan 7b passes through an upper surface of the cooling fin 6b, the cooling air hits against the upper surface cover 11b and a flow of the air is changed, with the result that the cooling air is flowed toward a front near side of the electric power conversion apparatus 1b from a back side thereof. In other words, after passing through the upper surface of the cooling fin 6b, the cooling air is flowed through the space provided between the opening portions 10b and the upper surface cover 11b, with the result that the cooling air is emitted to outside from a space on a front near side of the upper surface cover 11b.

Because the cooling air from the cooling fan 7b is for the forced air cooling, a flow of the cooling air is faster than that of cooling air for natural air cooling from a main circuit board 4b. Generally, a pressure is low in a place where a flow rate is high, and an object is attracted to the place where the pressure is low. In a case where the cooling air having a high flow rate is flowed by the cooling fan 7b between the opening portions 10b and the upper surface cover 11b by using this property, a pressure in a place near the opening portions 10b becomes low. With the low pressure, an upward flow of air is generated and heat radiated from the main circuit board 4b is attracted. As a result, the air having a flow rate higher than that of air for natural air cooling is flowed above the main circuit board 4b.

By providing the upper surface cover 11b as described above, the flow rate of the cooling air from the main circuit board 4b is higher than that of a conventional one. Therefore, cooling efficiency of the main circuit board 4b is improved.

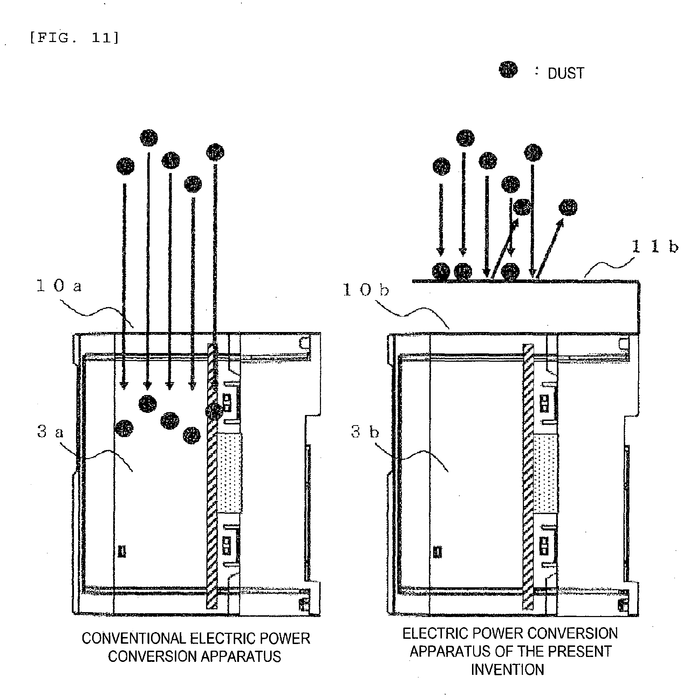

Further, because the upper surface cover 11b is provided above the opening portions 10b provided in the upper surface wall 9b of the main body casing 3b, it is possible to prevent dust from entering the inside of the main body casing 3b even if the dust is fallen from above the electric power conversion apparatus, as illustrated in Fig. 11. This improves reliability and safety of a product.

Further, conventionally, in a case where a plurality of electric power conversion apparatuses 1a are vertically provided, it is necessary to secure, above the electric power conversion apparatus 1a, a width for allowing warmed cooling air to flow therethrough so that the warmed cooling air emitted from the cooling fan 7a and the main circuit board 4a do not influence another electric power conversion apparatus 1a provided above. Therefore, the width needs to be provided between each pair of the electric power conversion apparatuses 1a. However, according to the invention, the cooling air from the cooling fan 7b and the cooling air from the main circuit board 4b are discharged from the front near side, and therefore, even in a case where a plurality of electric power conversion apparatuses 1b are vertically provided, a width does not need to be provided between each pair of the electric power conversion apparatuses 1b. This makes it possible to provide many electric power conversion apparatus 1b in a small space.

### Example 2

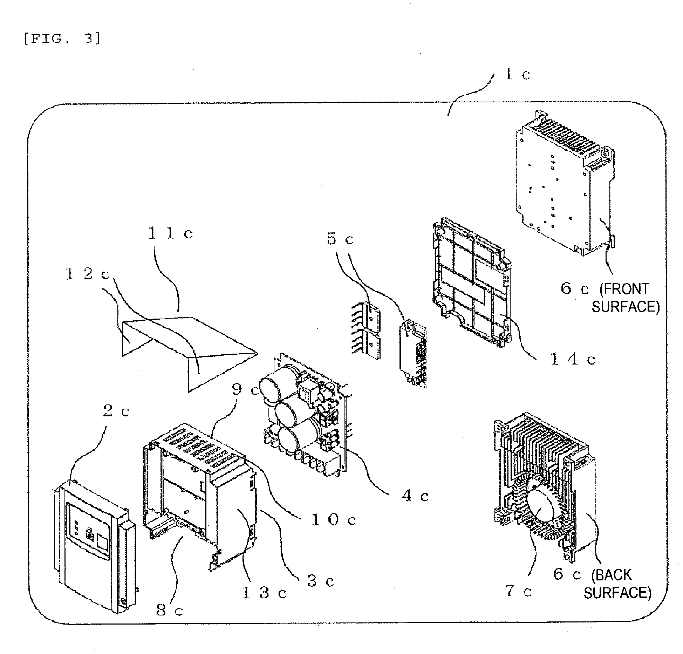

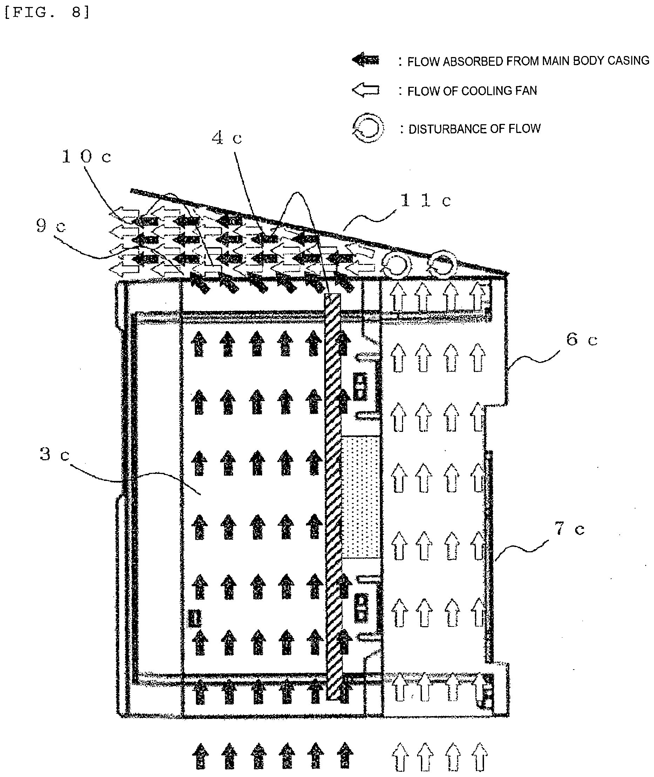

Fig. 3 is an example of a structural view of an electric power conversion apparatus 1c according to Example 2 of the invention. Fig. 8 is a cross-sectional view of the electric power conversion apparatus 1c in this example seen from a side thereof and illustrates a flow of cooling air. Also in this example, description of a structure similar to the structure in Example 1 is omitted, and a difference between this example and the conventional electric power conversion apparatus 1a will be described.

When seen from a side surface, an upper surface cover 11c in this example is obliquely widened toward a front near side from a surface at which the upper surface cover 11c is provided to the electric power conversion apparatus 1c, and, when seen from directly above the electric power conversion apparatus 1c, the upper surface cover 11c covers almost all a region of opening portions 10c. Specifically, a distance between an upper surface wall 9c and the upper surface cover 11c of the electric power conversion apparatus 1c becomes larger from a back side of the electric power conversion apparatus 1c toward a front near side thereof, and almost all cooling air emitted from a cooling fan 7c passes near the opening portions 10c and is then emitted to outside.

Because the upper surface cover 11c is inclined with respect to the upper surface wall 9c of the electric power conversion apparatus 1c, as illustrated in Fig. 8, it is possible to reduce a phenomenon that a flow of cooling air discharged from the cooling fan 7c is disturbed because the cooling air vertically hits against the upper surface cover 11c. The cooling air is flowed toward the front near side of the electric power conversion apparatus 1c while maintaining a high flow rate and is flowed along a periphery of the opening portions 10c of the upper surface wall 9c.

Comparing a case where the upper surface cover 11b is horizontally provided with respect to an upper surface of the electric power conversion apparatus 1b (Fig. 7) with a case where the upper surface cover 11c is inclined (Fig. 8), a flow of air in the inclined surface cover in Fig. 8 is less disturbed than that in the horizontal upper surface cover in Fig. 7. Thus, cooling air can be flowed at a high flow rate through a position nearer to the opening portions 10c and a lower pressure state can be achieved. Therefore, a flow of heat radiated from a main circuit board 4c provided in a main body casing 3c is attracted by the cooling air that is flowed at the high flow rate through the position near the opening portions 10c. Thus, the flow rate is higher than that of cooling air for natural convection. This improves a cooling effect. The cooling effect becomes larger in a case where the upper surface cover 11c is inclined than in a case where the upper surface cover is horizontally provided because a pressure in the position near the opening portions 10c can be lower in a case where the upper surface cover 11c is inclined.

This example can prevent dust, as in Example 1, and therefore the reliability and the safety of the product are improved.

In a case where the plurality of electric power conversion apparatuses 1c are vertically provided, the electric power conversion apparatuses 1c can be provided in a small space.

### Example 3

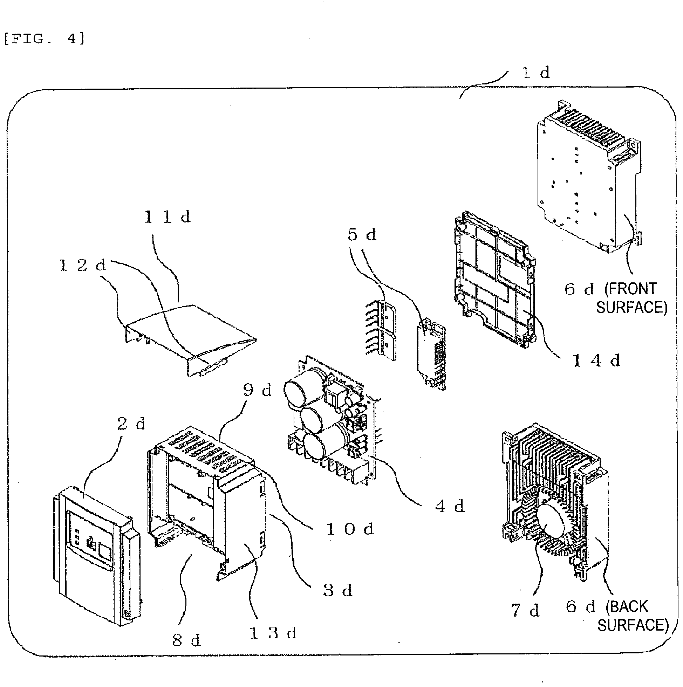

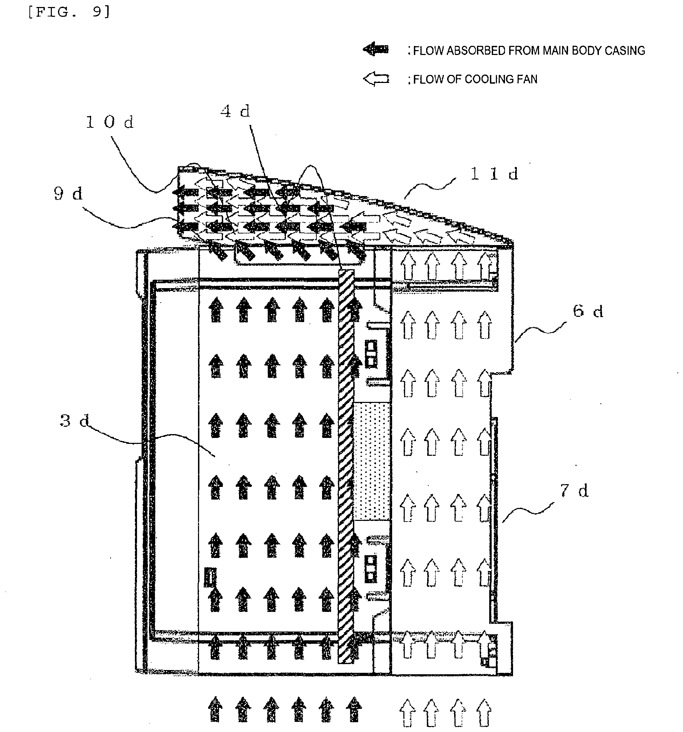

Fig. 4 is an example of a structural view of an electric power conversion apparatus 1d according to Example 3 of the invention. Fig. 9 is a cross-sectional view of the electric power conversion apparatus 1d in this example seen from a side thereof and illustrates a flow of cooling air. Also in this example, description of a structure similar to the structure in Example 1 is omitted, and a difference between this example and the conventional electric power conversion apparatus 1a will be described.

When seen from a side surface, an upper surface cover 11d in this example has such a plate shape that is widened toward a front near side from a surface at which the upper surface cover 11d is provided to the electric power conversion apparatus 1d while obliquely forming an arc, and, when seen from directly above the electric power conversion apparatus 1d, the upper surface cover 11d covers almost all a region of opening portions 10d. Specifically, this example and Example 2 are the same in that a distance between an upper surface wall 9d and the upper surface cover 11d of the electric power conversion apparatus 1d is widened from a back side of the electric power conversion apparatus 1d toward a front near side thereof and almost all cooling air emitted from a cooling fan 7d passes near the opening portions 10d and is then emitted to outside, however, this example is different from Example 2 in that the upper surface cover 11d has an arc shape.

Because the upper surface cover 11d has the arc shape while being inclined with respect to the upper surface wall 9d of the electric power conversion apparatus 1d, a reflection angle obtained when air hits against a wall surface locally becomes shallow. Therefore, as illustrated in Fig. 9, cooling air can be flowed at a high flow rate through a position near the opening portions 10d without disturbing a flow of the air in comparison with Example 2.

Comparing a case where the upper surface cover 11d is linearly inclined with respect to an upper surface of the electric power conversion apparatus 1c as described in Example 2 (Fig. 8) with a case where the upper surface cover 11d is smoothly provided while forming the arc shape (Fig. 9), the flow of the air in the arc-shaped upper surface cover in Fig. 9 is less disturbed than that in the linear upper surface cover in Fig. 8. Thus, cooling air can be flowed at a high flow rate through a position nearer to the opening portions 10d and a lower pressure state can be achieved. Therefore, a flow of heat radiated from a main circuit board 4d provided in a main body casing 3d is attracted by the cooling air that is flowed at the high flow rate through the position near the opening portions 10d. Thus, the flow rate is higher than that of cooling air for natural convection. This improves a cooling effect. The cooling effect becomes larger in a case where the upper surface cover 11d has the arc shape than in a case where the upper surface cover is linearly inclined because a pressure in the position near the opening portions 10d can be lower in a case where the upper surface cover 11d has the arc shape.

Further, because the upper surface cover 11d has the arc shape, it is possible to improve a strength of the upper surface cover 11d itself.

This example can prevent dust, as in Example 1, and therefore the reliability and the safety of the product are improved.

In a case where the plurality of electric power conversion apparatuses 1d are vertically provided, the electric power conversion apparatuses 1d can be provided in a small space.

### Example 4

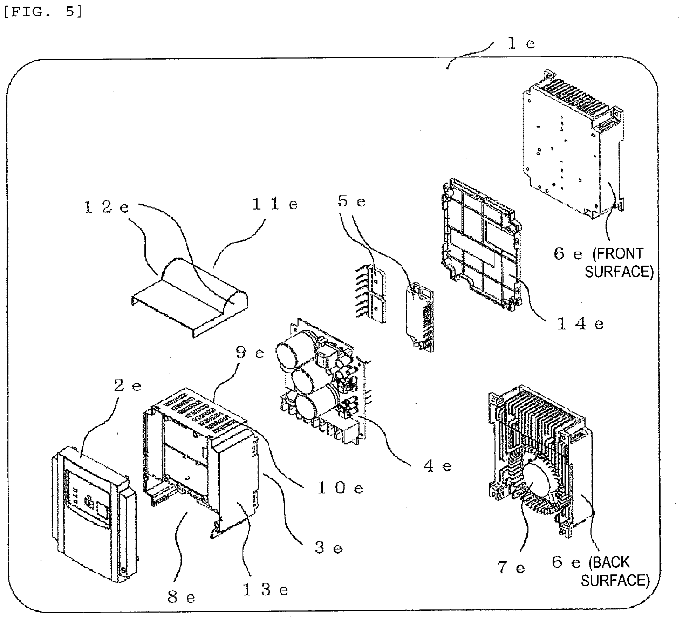

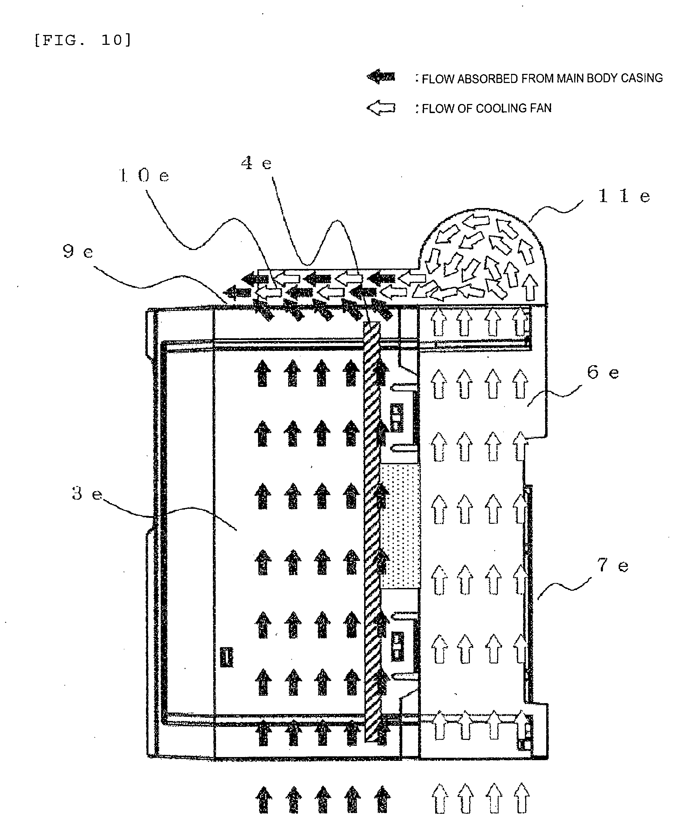

Fig. 5 is an example of a structural view of an electric power conversion apparatus 1e according to Example 4 of the invention. Fig. 10 is a cross-sectional view of the electric power conversion apparatus 1e in this example seen from a side thereof and illustrates a flow of cooling air. Also in this example, description of a structure similar to the structure in Example 1 is omitted, and a difference between this example and the conventional electric power conversion apparatus 1a will be described.

When seen from directly above an upper surface cover 11e, a region of opening portions 10e is covered by the upper surface cover 11e, and, when seen from a side surface, the upper surface cover 11e in this example is widened toward a front near side from a surface at which the upper surface cover 11e is provided to the electric power conversion apparatus 1e while obliquely forming an arc and a space distance between an upper surface wall 9e and the upper surface cover 11e is reduced in the middle near the opening portions 10e of the electric power conversion apparatus 1e.

That is, this example and Example 3 are the same in that the upper surface cover 11e above a cooling fin 6e has an arc shape, however, this example is structured to have a large space distance between the cooling fin 6e and the upper surface cover 11e above the cooling fin 6e and have a small space distance between the upper surface wall 9e and the upper surface cover 11e above the opening portions 10e.

Generally, in a case where fluid is flowed from a wide portion to a narrow portion of a flow channel, a flow rate becomes higher.

In other words, it is possible to cause a flow rate of cooling air directly above the opening portions 10e to be flowed higher than that of the cooling air emitted from a cooling fan 7e.

Comparing a case where the upper surface cover is smoothly widened toward an outside part with respect to an upper surface of the electric power conversion apparatus 1d while forming the arc shape as described in Example 3 (Fig. 9) with a case where the upper surface cover 11e is smoothly widened while forming the arc shape and a space distance directly above the opening portions 10e is small (Fig. 10), cooling air can be flowed at a high flow rate through a position nearer to the opening portions 10e and a lower pressure state can be achieved in a case where the air is flowed from a wide flow channel (space distance) to a narrow flow channel (space distance). Therefore, a flow of heat radiated from a main circuit board 4e provided in a main body casing 3e is attracted by cooling air that is flowed at the high flow rate through the position near the opening portions 10e. Thus, the flow rate is higher than that of cooling air for natural convection. This improves a cooling effect. The cooling effect becomes larger in a case where the upper surface cover 11e is structured so that the air is flowed from the wide flow channel (space distance) to the narrow flow channel (space distance) than in a case where the upper surface cover is widened toward outside while forming the arc shape because a pressure in the position near the opening portions 10e can be lower in a case where the air is flowed from the wide flow channel to the narrow flow channel.

Further, it is possible to improve a strength of the upper surface cover 11e itself, as in Example 3.

This example can prevent dust, as in Example 1, and therefore the reliability and the safety of the product are improved.

In a case where the plurality of electric power conversion apparatuses 1e are vertically provided, the electric power conversion apparatuses 1e can be provided in a small space.

### Example 5

In Examples 1 to 4, the walls are provided on the right and left side surfaces and on the back side surface of each of the upper surface covers 11b to 11e so that cooling air cannot be flowed in and flowed out, however, those walls may be or may not be provided. In a case where the walls are not provided, dust can be prevented from entering inside through the opening portions and the electric power conversion apparatus can be provided in a small space in a vertical direction.

Further, the walls on the right and left side surfaces and on the back side surface of each of the upper surface covers 11b to 11e in Examples 1 to 4 may be removed and attached as necessary. In this case, it is possible to use the electric power conversion apparatus in accordance with a characteristic of a space in which the electric power conversion apparatus is installed, and therefore, provision of the electric power conversion apparatus in a small space and improvement in a cooling effect can be achieved in response to a user's need.

The upper surface cover may cover the whole surface or cover a part of the surface.

In Examples 1 to 4, flows of the cooling air emitted from the cooling fans 7b to 7e are changed by the upper surface covers 11b to 11e, respectively, and the cooling air passes above the opening portions 10b to 10e of the electric power conversion apparatuses 1b to 1e and is emitted to outside toward front sides of the electric power conversion apparatuses 1b to 1e. However, as long as cooling air is flowed at a high flow rate directly above regions of the opening portions 10b to 10e of the electric power conversion apparatuses 1b to 1e, a direction of the cooling air emitted to the outside after passing above the regions is not limited to the front sides . In all examples, cooling air is flowed at a high flow rate directly above the regions of the opening portions 10b to 10e of the electric power conversion apparatuses 1b to 1e.

The examples have been described in detail to make it easier to understand the invention, however, the invention is not always limited to electric power conversion apparatus having all structures described above. Further, a part of a structure of a certain example can be replaced with that of another example, and a structure of another example can be added to a structure of a certain example. Furthermore, a part of a structure of each example can be added to, removed from, replaced with another structure.

### Reference Signs List

- 1a: conventional electric power conversion apparatus
- 2a: surface cover
- 3a: main body casing
- 4a: main circuit board
- 5a: semiconductor
- 6a: cooling fin
- 7a: cooling fan
- 8a: lower surface of main body casing
- 9a: upper surface wall of main body casing
- 10a: opening portion
- 11a: cooling fin base surface
- 1b: electric power conversion apparatus of Example 1
- 2b: surface cover
- 3b: main body casing
- 4b: main circuit board
- 5b: semiconductor
- 6b: cooling fin
- 7b: cooling fan
- 8b: lower surface of main body casing
- 9b: upper surface wall of main body casing
- 10b: opening portion
- 11b: upper surface cover
- 12b: right and left side walls of upper surface cover
- 13b: right and left side walls of main body casing
- 14b: shielding plate
- 1c: electric power conversion apparatus of Example 2
- 2c: surface cover
- 3c: main body casing
- 4c: main circuit board
- 5c: semiconductor
- 6c: cooling fin
- 7c: cooling fan
- 8c: lower surface of main body casing
- 9c: upper surface wall of main body casing
- 10c: opening portion
- 11c: upper surface cover
- 12c: right and left side walls of upper surface cover
- 13c: right and left side walls of main body casing
- 14c: shielding plate
- 1d: electric power conversion apparatus of Example 3
- 2d: surface cover
- 3d: main body casing
- 4d: main circuit board
- 5d: semiconductor
- 6d: cooling fin
- 7d: cooling fan
- 8d: lower surface of main body casing
- 9d: upper surface wall of main body casing
- 10d: opening portion
- 11d: upper surface cover
- 12d: right and left side walls of upper surface cover
- 13d: right and left side walls of main body casing
- 14d: shielding plate
- 1e: electric power conversion apparatus of Example 4
- 2e: surface cover
- 3e: main body casing
- 4e: main circuit board
- 5e: semiconductor
- 6e: cooling fin
- 7e: cooling fan
- 8e: lower surface of main body casing
- 9e: upper surface wall of main body casing
- 10e: opening portion
- 11e: upper surface cover
- 12e: right and left side walls of upper surface cover
- 13e: right and left side walls of main body casing
- 14e: shielding plate

## Claims

1. An electric power conversion apparatus, comprising:
a semiconductor (5);
a main circuit board (4) having a circuit for driving the semiconductor;
a casing (3) housing the semiconductor and the main circuit board and having an opening for the flow-in of first cooling air and an upper surface (9) in which an opening portion (10) is provided for the first cooling air to flow out upwardly in use of the electric power conversion apparatus; and
a cover (11) above the opening portion of the casing, with a predetermined gap between the cover and the opening portion of the casing,
**characterised by**:
a cooling fin (6) on the back of the casing, the cooling fin being for radiating heat from the semiconductor, wherein the cover is provided above both the opening portion of the casing and the cooling fin and has the predetermined gap above the opening portion and the cooling fin; and
a cooling fan (7) for forced air cooling of the cooling fin by second cooling air emitted by the fan and passing the cooling fin on the back surface of the casing, wherein the second cooling air from the cooling fin flows upwards and further flows through the gap between the cover (11) and the opening portion (10) of the casing thereby attracting the first cooling air from the opening portion of the casing, and the second cooling air from the cooling fin and the first cooling air from the opening portion (10) of the casing are emitted from an opening portion of the cover (11).

2. The electric power conversion apparatus according to claim 1,
wherein cooling air from the cooling fin is flowed near the opening portion (10) of the casing by changing a direction of the cooling air by hitting the cooling air against the cover.

3. The electric power conversion apparatus according to claim 2, wherein
the cooling air that is emitted from the cooling fin and is flowed near the opening portion (10) of the casing is faster than cooling air emitted from the opening portion of the casing.

4. The electric power conversion apparatus according to any of claims 1 to 3, wherein
cooling air from the cooling fin and cooling air from the opening portion (10) of the casing are flowed toward a front side from a back side in a state in which the electric power conversion apparatus is used.

5. The electric power conversion apparatus according to any of claims 1 to 4, wherein
a flow rate of cooling air that is emitted from the opening portion (10) of the casing becomes higher than the flow rate in the electric power conversion apparatus due to cooling air that is emitted from the cooling fin and is flowed near the opening portion of the casing by changing a direction of the cooling air by hitting the cooling air against the cover.

6. The electric power conversion apparatus according to any of claims 1 to 5, wherein
the cover is placed so that a distance between the surface of the casing in which the opening portion (10) is provided and the cover is substantially the same.

7. The electric power conversion apparatus according to any of claims 1 to 6, wherein
the cover (11) and the surface of the casing in which the opening portion is provided are in parallel to each other.

8. The electric power conversion apparatus according to any of claims 1 to 5, wherein
a distance between the cover (11) and the surface of the casing in which the opening portion is provided is larger in a front side than in a back side of the electric power conversion apparatus in a state in which the electric power conversion apparatus is used.

9. The electric power conversion apparatus according to any of claims 1 to 5 and 8, wherein
a distance between the cover (11) and the surface of the casing in which the opening portion is provided becomes larger toward a front side from a back side of the electric power conversion apparatus in a state in which the electric power conversion apparatus is used.

10. The electric power conversion apparatus according to any of claims 1 to 5, 8 and 9, wherein
the cover (11) is inclined with respect to the surface of the casing in which the opening portion is provided.

## Patentansprüche

1. Elektrische Leistungswandlervorrichtung umfassend:
einen Halbleiter (5);
eine Hauptschaltungsplatine (4) mit einer Schaltung zum Ansteuern des Halbleiters;
ein Gehäuse (3), das den Halbleiter und die Hauptschaltungsplatine aufnimmt und eine Öffnung zum Einströmen erster Kühlluft sowie eine obere Fläche (9) aufweist, in der ein Öffnungsabschnitt (10) vorgesehen ist, damit die erste Kühlluft bei Verwendung der elektrischen Leistungswandlervorrichtung nach oben ausströmen kann; und
eine Abdeckung (11) oberhalb des Öffnungsabschnitts des Gehäuses, wobei zwischen der Abdeckung und dem Öffnungsabschnitt des Gehäuses eine vorbestimmte Lücke besteht,
**gekennzeichnet durch**:
eine Kühlrippe (6) auf der Rückseite des Gehäuses, um Wärme vom Halbleiter abzustrahlen, wobei die Abdeckung oberhalb sowohl des Öffnungsabschnitts des Gehäuses als auch der Kühlrippe vorgesehen ist und die vorbestimmte Lücke oberhalb des Öffnungsabschnitts und der Kühlrippe aufweist; und
einen Kühlventilator (7) zur erzwungenen Luftkühlung der Kühlrippe mittels zweiter Kühlluft, die vom Ventilator abgegeben wird und die Kühlrippe auf der rückwärtigen Fläche des Gehäuses passiert, wobei die zweite Kühlluft von der Kühlrippe aufwärts strömt und weiter durch die Lücke zwischen der Abdeckung (11) und dem Öffnungsabschnitt (10) des Gehäuses strömt, wodurch die erste Kühlluft aus dem Öffnungsabschnitt des Gehäuses angesogen wird, und wobei die zweite Kühlluft von der Kühlrippe und die erste Kühlluft von dem Öffnungsabschnitt (10) des Gehäuses aus einem Öffnungsabschnitt der Abdeckung (11) austreten.

2. Elektrische Leistungswandlervorrichtung nach Anspruch 1, wobei die Kühlluft von der Kühlrippe nahe dem Öffnungsabschnitt (10) des Gehäuses strömt, indem ihre Richtung durch Auftreffen der Kühlluft an der Abdeckung geändert wird.

3. Elektrische Leistungswandlervorrichtung nach Anspruch 2, wobei
die Kühlluft, die von der Kühlrippe abgegeben wird und nahe dem Öffnungsabschnitt (10) des Gehäuses strömt, schneller als die Kühlluft ist, die von dem Öffnungsabschnitt des Gehäuses abgegeben wird.

4. Elektrische Leistungswandlervorrichtung nach einem der Ansprüche 1 bis 3, wobei
Kühlluft von der Kühlrippe und Kühlluft vom Öffnungsabschnitt (10) des Gehäuses bei Verwendung der elektrischen Leistungswandlervorrichtung von einer rückwärtigen Seite zur vorderen Seite strömen.

5. Elektrische Leistungswandlervorrichtung nach einem der Ansprüche 1 bis 4, wobei
aufgrund der Kühlluft, die von der Kühlrippe abgegeben wird und nahe des Öffnungsabschnitts des Gehäuses strömt, indem ihre Richtung durch Auftreffen der Kühlluft auf die Abdeckung geändert wird, eine Strömungsrate derjenigen Kühlluft, die von dem Öffnungsabschnitt (10) des Gehäuses abgegeben wird, größer als die Strömungsrate in der elektrischen Leistungswandlervorrichtung wird.

6. Elektrische Leistungswandlervorrichtung nach einem der Ansprüche 1 bis 5, wobei
die Abdeckung so angeordnet ist, dass der Abstand zwischen der Oberfläche des Gehäuses, in der der Öffnungsabschnitt (10) vorgesehen ist, und der Abdeckung im Wesentlichen gleichförmig ist.

7. Elektrische Leistungswandlervorrichtung nach einem der Ansprüche 1 bis 6, wobei
die Abdeckung (11) und die Oberfläche des Gehäuses, in der der Öffnungsabschnitt vorgesehen ist, parallel zueinander sind.

8. Elektrische Leistungswandlervorrichtung nach einem der Ansprüche 1 bis 5, wobei
der Abstand zwischen der Abdeckung (11) und der Oberfläche des Gehäuses, in der der Öffnungsabschnitt vorgesehen ist, auf einer bei Verwendung der elektrischen Leistungswandlervorrichtung vorderen Seite größer als bei der rückwärtigen Seite der elektrischen Leistungswandlervorrichtung ist.

9. Elektrische Leistungswandlervorrichtung nach einem der Ansprüche 1 bis 5 und 8, wobei
der Abstand zwischen der Abdeckung (11) und der Oberfläche des Gehäuses, in der der Öffnungsabschnitt vorgesehen ist, von einer bei Verwendung der elektrischen Leistungswandlervorrichtung rückwärtigen Seite zur vorderen Seite der elektrischen Leistungswandlervorrichtung hin größer wird.

10. Elektrische Leistungswandlervorrichtung nach einem der Ansprüche 1 bis 5, 8 und 9, wobei
die Abdeckung (11) bezüglich der Oberfläche des Gehäuses, in der der Öffnungsabschnitt vorgesehen ist, geneigt ist.

## Revendications

1. Appareil de conversion de puissance électrique, comprenant :
un semi-conducteur (5) ;
une carte de circuit principale (4) ayant un circuit pour piloter le semi-conducteur ;
un boîtier (3) logeant le semi-conducteur et la carte de circuit principale et ayant une ouverture pour l'admission d'un premier air de refroidissement et une surface supérieure (9) dans laquelle une partie d'ouverture (10) est prévue pour que le premier air de refroidissement s'échappe vers le haut lors de l'utilisation de l'appareil de conversion de puissance électrique ; et
un capot (11) au-dessus de la partie d'ouverture du boîtier, avec un espace prédéterminé entre le capot et la partie d'ouverture du boîtier,
**caractérisé par** :
une ailette de refroidissement (6) sur l'arrière du boîtier, l'ailette de refroidissement servant à faire rayonner une chaleur provenant du semi-conducteur, dans lequel le capot est prévu au-dessus à la fois de la partie d'ouverture du boîtier et de l'ailette de refroidissement et a l'espace prédéterminé au-dessus de la partie d'ouverture et de l'ailette de refroidissement ; et
un ventilateur de refroidissement (7) pour un refroidissement par air forcé de l'ailette de refroidissement par un deuxième air de refroidissement émis par le ventilateur et passant par l'ailette de refroidissement sur la surface arrière du boîtier, dans lequel le deuxième air de refroidissement provenant de l'ailette de refroidissement s'écoule vers le haut et s'écoule en outre à travers l'espace entre le capot (11) et la partie d'ouverture (10) du boîtier, attirant ainsi le premier air de refroidissement provenant de la partie d'ouverture du boîtier, et le deuxième air de refroidissement provenant de l'ailette de refroidissement et le premier air de refroidissement provenant de la partie d'ouverture (10) du boîtier sont émis depuis une partie d'ouverture du capot (11).

2. Appareil de conversion de puissance électrique selon la revendication 1,
dans lequel l'air de refroidissement provenant de l'ailette de refroidissement est fait s'écouler à proximité de la partie d'ouverture (10) du boîtier en changeant une direction de l'air de refroidissement en faisant frapper l'air de refroidissement contre le capot.

3. Appareil de conversion de puissance électrique selon la revendication 2, dans lequel
l'air de refroidissement qui est émis depuis l'ailette de refroidissement et est fait s'écouler à proximité de la partie d'ouverture (10) du boîtier est plus rapide que l'air de refroidissement émis depuis la partie d'ouverture du boîtier.

4. Appareil de conversion de puissance électrique selon l'une quelconque des revendications 1 à 3, dans lequel
l'air de refroidissement provenant de l'ailette de refroidissement et l'air de refroidissement provenant de la partie d'ouverture (10) du boîtier sont fait s'écouler vers un côté avant depuis un côté arrière dans un état dans lequel l'appareil de conversion de puissance électrique est utilisé.

5. Appareil de conversion de puissance électrique selon l'une quelconque des revendications 1 à 4, dans lequel
un débit de l'air de refroidissement qui est émis depuis la partie d'ouverture (10) du boîtier devient supérieur au débit dans l'appareil de conversion de puissance électrique du fait de l'air de refroidissement qui est émis depuis l'ailette de refroidissement et est fait s'écouler à proximité de la partie d'ouverture du boîtier en changeant une direction de l'air de refroidissement en faisant frapper l'air de refroidissement contre le capot.

6. Appareil de conversion de puissance électrique selon l'une quelconque des revendications 1 à 5, dans lequel
le capot est placé de telle manière qu'une distance entre la surface du boîtier dans laquelle la partie d'ouverture (10) est prévue et le capot est sensiblement la même.

7. Appareil de conversion de puissance électrique selon l'une quelconque des revendications 1 à 6, dans lequel
le capot (11) et la surface du boîtier dans laquelle la partie d'ouverture est prévue sont parallèles l'un à l'autre.

8. Appareil de conversion de puissance électrique selon l'une quelconque des revendications 1 à 5, dans lequel
une distance entre le capot (11) et la surface du boîtier dans laquelle la partie d'ouverture est prévue est plus grande dans un côté avant que dans un côté arrière de l'appareil de conversion de puissance électrique dans un état dans lequel l'appareil de conversion de puissance électrique est utilisé.

9. Appareil de conversion de puissance électrique selon l'une quelconque des revendications 1 à 5 et 8, dans lequel
une distance entre le capot (11) et la surface du boîtier dans laquelle la partie d'ouverture est prévue devient plus grande vers un côté avant depuis un côté arrière de l'appareil de conversion de puissance électrique dans un état dans lequel l'appareil de conversion de puissance électrique est utilisé.

10. Appareil de conversion de puissance électrique selon l'une quelconque des revendications 1 à 5, 8 et 9, dans lequel
le capot (11) est incliné par rapport à la surface du boîtier dans laquelle la partie d'ouverture est prévue.
